# EUROPEAN PATENT APPLICATION

(11) **EP 2 325 909 A1**
(43) Date of publication of application: **25.05.2011**
(21) Application number: 09176926.5
(22) Date of filing: 24.11.2009
(51) Int. Cl.: H01L 41/09, B81B 3/00, H01L 41/22

(54) **MEMS device and method of fabrication**

(71) Applicant: BAE Systems PLC, London SW1Y 5AD (GB)
(72) Inventor: The designation of the inventor has not yet been filed
(74) Representative: BAE SYSTEMS plc Group IP Department

(57) **Abstract**

A MEMS device (e.g. a piezoelectric actuator), and method of fabrication thereof, having a moveable portion comprising a layer of material (6) (e.g. a substrate layer formed from a substrate wafer) having relatively low rigidity in a direction in the plane of a surface of the layer of material (6), and relatively high rigidity in a direction through the plane; wherein the relatively low rigidity is provided by ridges and grooves (60) in a further surface of the layer of material (6), the further surface of the material (6) being substantially perpendicular to the direction in the plane. The MEMS device may comprise a layer of piezoelectric material (2) bonded to the surface of the layer of material (6). Actuation of the MEMS device (e.g. actuation in the plane of the surface of the layer of material (6)) may be performed by applying an electrical field across the piezoelectric material.

## Description

The present invention relates to Micro Electro Mechanical System (MEMS) devices and the fabrication thereof.

### BACKGROUND

Micro Electro Mechanical System (MEMS) devices are known. One type of known MEMS device is an MEMS actuator in which an electric field is applied across a piezoelectric material to produce a small strain, which is used to actuate the device. Such devices have a wide range of potential applications, for example, actuators in aircraft, or accelerometers.

Typical manufacturing requirements for MEMS actuators include small size, mass-producibility, high reliability and good energy efficiency.

There is a general need for MEMS devices that provide actuation movement within the plane of their manufacture, i.e. within the plane of the layers of material that the MEMS device is formed from, whilst maintaining the aforementioned requirements. Conventionally, this need is met by MEMS devices that provide actuation out of the plane of the components being manufactured and then removed and reconnected such that the actuation is in the required direction. However, this process tends to be costly, time-consuming, and lacks manufacturing flexibility, e.g. with regard to interconnecting groups of devices with each other and/or with other elements such as drive electronics.

### SUMMARY OF THE INVENTION

In a first aspect, the present invention provides a MEMS device having a moveable portion, the moveable portion comprising a layer of material having relatively low rigidity in a direction in the plane of a surface of the layer of material, and relatively high rigidity in a direction through the plane of the surface; wherein the relatively low rigidity is provided by a plurality of alternating ridges and grooves in a further surface of the layer of material, the further surface of the material being substantially perpendicular to the direction in the plane of a surface of the layer of material.

The layer of material may be a substrate layer formed from a substrate wafer.

The plane of the surface of the layer of material may be the plane of the substrate wafer onto which the MEMS device is formed.

The MEMS device may be a piezoelectric actuator.

The MEMS device may further comprise a layer of piezoelectric material bonded to the surface of the layer of material, wherein actuation of the MEMS device is performed by applying an electrical field across the layer of piezoelectric material.

Actuation of the MEMS device may be in the plane of the surface of the layer of material.

Actuation of the MEMS device may be bidirectional within the plane of the surface of the layer of material.

The MEMS device may be adapted to provide a pre-determined actuation force and/or actuation displacement by varying, during fabrication of the MEMS device, one or more of the following: the number of alternating ridges and grooves; the distribution of the ridges and grooves in the further surface; the depth of one or more of the plurality of grooves relative to the ridges; the width of one or more of the plurality of ridges; and the width of one or more of the plurality of grooves.

In a further aspect, the present invention provides a method of fabricating a MEMS device, the method comprising the steps of: providing a layer of material having relatively high rigidity in a direction through the plane of a surface of the layer of material; and forming a plurality of alternating ridges and grooves in a further surface of the layer of material, the further surface of the material being substantially perpendicular to a direction in the plane of a surface of the layer of material, such that the layer of material has relatively low rigidity in the direction in the plane of a surface of the layer of material.

The layer of material may be a substrate layer formed from a substrate wafer, and the plane of the surface of the layer of material is the plane of the substrate wafer onto which the MEMS device is formed.

The method may further comprise adapting the MEMS device to provide a pre-determined actuation force and/or actuation displacement by performing one or more of the following steps: determining the number of alternating ridges and grooves; determining the distribution of the ridges and grooves in the further surface; determining the depth of one or more of the plurality of grooves relative to the ridges; determining the width of one or more of the plurality of ridges; and determining the width of one or more of the plurality of grooves.

The method may further comprise the step of bonding a layer of piezoelectric material to the surface of the layer of material.

In a further aspect, the present invention provides a method of actuating a MEMS device, wherein the MEMS device is fabricated according to the above aspect, and the method of actuation comprises the step of applying an electrical field across the layer of piezoelectric material.

The actuation of the MEMS device may be bidirectional within the plane of the surface of the layer of material.

### BRIEF DESCRIPTION OF THE DRAWINGS

Figure 1 is a process flowchart showing certain process steps carried out in an embodiment of a fabrication process for fabricating a MEMS device;
Figure 2 is a schematic illustration of a side view of a piezoelectric material provided at step s2 of the process of Figure 1;
Figure 3 is a schematic illustration of the side view of a device formed by performing steps s2 to s4 of the process of Figure 1;
Figure 4 is a schematic illustration of the side view of a device formed by performing steps s2 to s6 of the process of Figure 1;
Figure 5 is a schematic illustration of the side view of a device formed by performing steps s2 to s8 of the process of Figure 1;
Figure 6 is a schematic illustration of the side view of a device formed by performing steps s2 to s10 of the process of Figure 1;
Figure 7 is a schematic illustration of a top-down view of a device formed by performing steps s2 to s12 of the process of Figure 1;
Figure 8A is a schematic illustration of a top-down view of a device formed by performing steps s2 to s14 of the process of Figure 1;
Figure 8B is a schematic illustration of a side view of a device formed by performing steps s2 to s14 of the process of Figure 1;
Figure 9A is schematic illustrations of a top-down view of the MEMS device formed by performing the process of Figure 1;
Figure 9B schematic illustrations of a side view of the MEMS device formed by performing the process of Figure 1;
Figure 10 is a schematic illustration of a top down view of the substrate of the MEMS device;
Figure 11A is a schematic illustration of a side view corresponding to a first edge of the MEMS device during an example of operation;
Figure 11B is a schematic illustration of a side view corresponding to a second edge of the MEMS device during an example of operation; and
Figure 12 is a schematic illustration of a top down view of the MEMS device during an example of operation.

### DETAILED DESCRIPTION

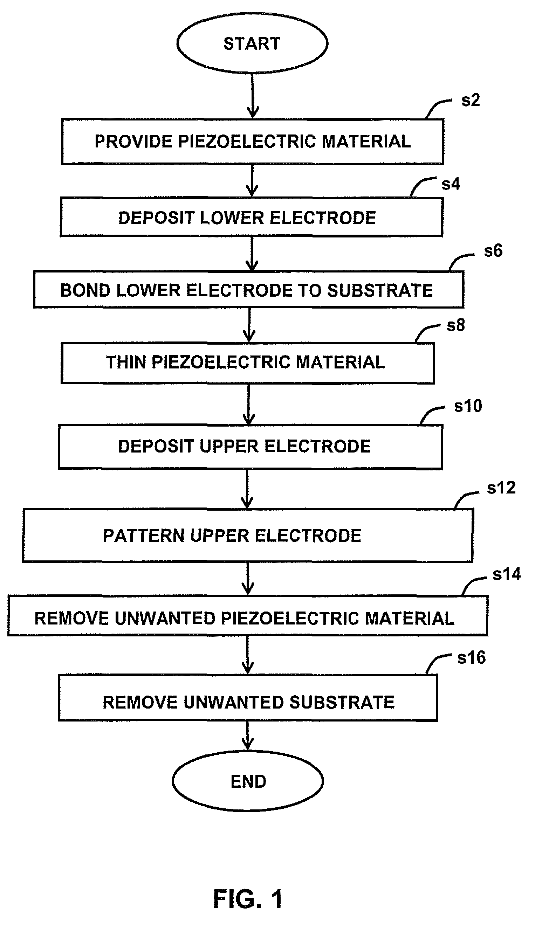

Figure 1 is a process flowchart showing certain process steps carried out in an embodiment of a fabrication process for fabricating a MEMS device. Terminology used in the description of the process that describes relative positions of elements of the MEMS device, such as 'the top', 'the bottom' etc. is used in a merely relative sense for ease of reference and is non-limiting.

At step s2, a section of piezoelectric material, hereinafter referred to as "the piezoelectric material 2" is provided. In this embodiment, the piezoelectric material 2 is lead zirconate titanate (PZT). The piezoelectric material 2 has substantially uniform thickness. The surfaces of the piezoelectric material are substantially flat. Also, opposite surfaces of the piezoelectric material 2 are substantially parallel to each other. The piezoelectric material 2 is 0.001 m (1 mm) thick.

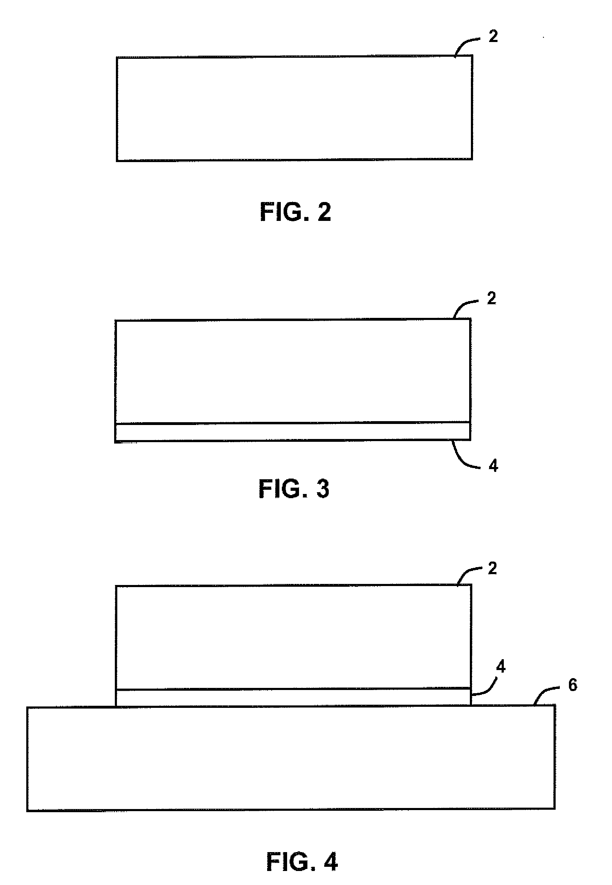

Figure 2 is a schematic illustration (not to scale) of a side view of the piezoelectric material 2 provided at step s2.

At step s4, an electrode, hereinafter referred to as the "lower electrode 4" is deposited on to the bottom of the piezoelectric material 2. The lower electrode 4 comprises a layer of chrome, and a layer of gold. The layer of chrome is deposited on to the bottom of the piezoelectric material 2. The layer of chrome is 50x10⁻⁹m (50nm) thick. The layer of gold is deposited onto the layer of chrome. The layer of gold is 0.5x10⁻⁶m (0.5µm) thick.

Figure 3 is a schematic illustration (not to scale) of the side view of a device formed by performing steps s2 to s4 as described above.

At step s6, the lower electrode 4 is bonded to a substrate 6. In this embodiment, the layer of gold of the lower electrode 4 is boded to the substrate 6. The substrate 6 is silicon. The substrate 6 is 500x10⁻⁶m (500µm) thick.

Figure 4 is a schematic illustration (not to scale) of the side view of a device formed by performing steps s2 to s6 as described above.

At step s8, the piezoelectric material 2 is thinned. In this embodiment the piezoelectric material 2 is by grinding down the piezoelectric material 2 until the layer of piezoelectric material 2 is 20x10⁻⁶m (20pm) thick.

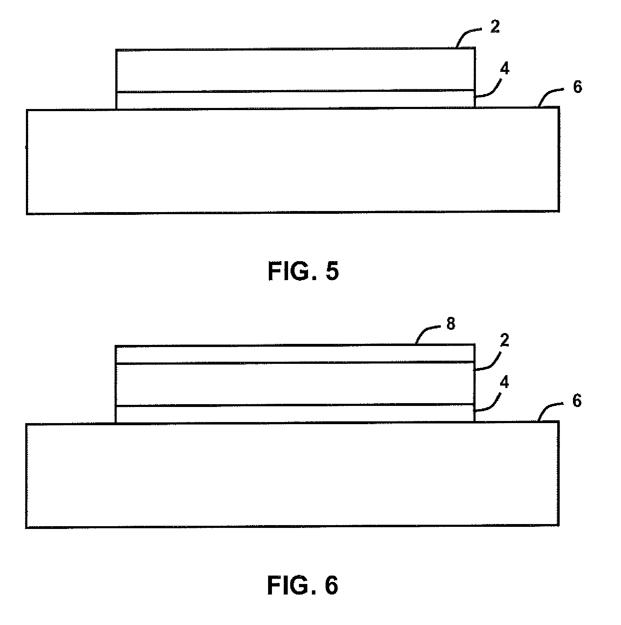

Figure 5 is a schematic illustration (not to scale) of the side view of a device formed by performing steps s2 to s8 as described above.

At step s10, an electrode, hereinafter referred to as the "upper electrode 8" is deposited on to the top of the piezoelectric material 2. The upper electrode 8 comprises a layer of chrome, and a layer of gold. The layer of chrome is deposited on to the top of the piezoelectric material 2. The layer of chrome is 50x10⁻⁹m (50nm) thick. The layer of gold is deposited onto the layer of chrome. The layer of gold is 0.5x10⁻⁶m (0.5pm) thick.

Figure 6 is a schematic illustration (not to scale) of the side view of a device formed by performing steps s2 to s10 as described above.

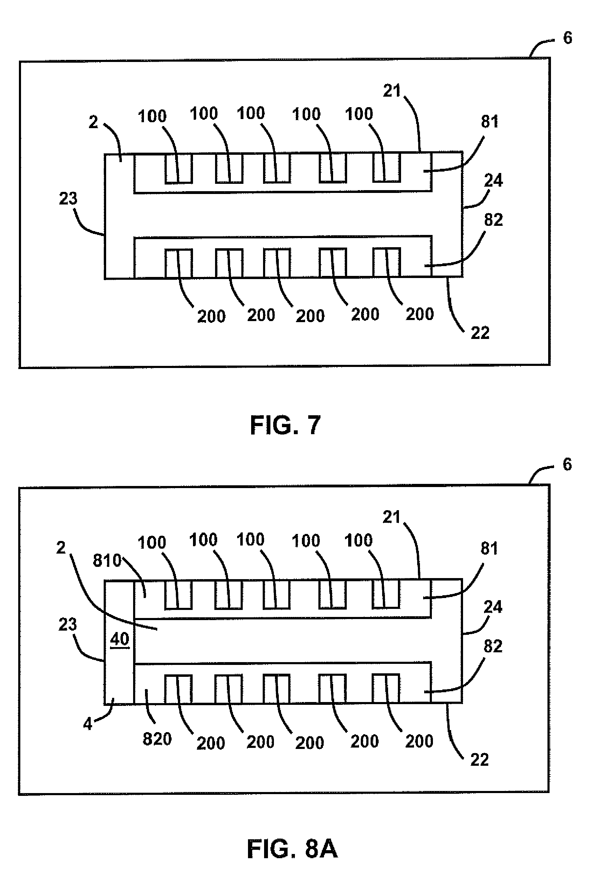

At step s12 the upper electrode 8 is patterned, as described in more detail later below with reference to Figure 7. Steps s14 and s16 of the fabrication process for fabricating a MEMS device are described after the description of Figure 7.

Figure 7 is a schematic illustration (not to scale) of a top-down view of a device formed by performing steps s2 to s12.

The top surface of the piezoelectric material 2 is substantially rectangular, having a first long edge (hereinafter referred to as "the first edge 21 "), a second long edge, (hereinafter referred to as "the first edge 21 "), a first short edge (hereinafter referred to as "the third edge 23"), and a second short edge, (hereinafter referred to as "the fourth edge 24"). The first edge 21 and the second edge 22 of the top surface of the piezoelectric material 2 are parallel. The third edge 23 and the fourth edge 24 of the top surface of the piezoelectric material 2 are parallel. The first and second edges 21, 22 of the top surface of the piezoelectric material 2 are perpendicular to the third and fourth edges 23, 24 of the top surface of the piezoelectric material 2.

The upper electrode 8 is patterned such that the upper electrode 8 comprises two strips of electrode material, hereinafter referred to as "the first electrode strip 81" and "the second electrode strip 82".

The first electrode strip 81 is positioned on the top surface of the piezoelectric material 2 such that it is parallel to, and connected to, the first edge 21 of the top surface of the piezoelectric material 2. The first electrode strip 81 is separated from the third edge 23 by a gap. The first electrode strip 81 is separated from the fourth edge 24 by a gap.

The first electrode strip 81 is patterned such that the edge of the first electrode 81 that is connected to the first edge 21 has a series of notches, referred to hereinafter as "the first set of notches", each of which is indicated in Figure 7 by the reference numeral 100. In this embodiment, the first set of notches 100 comprises five notches. The notches of the first set of notches 100 are substantially rectangular. The notches of the first set of notches 100 are of substantially equal size. The notches of the first set of notches 100 are equally spaced along the edge of the first electrode strip 81 that is connected to the first edge 21 of the piezoelectric material 2.

The first electrode strip 81 is separated from the second electrode strip 82 by a gap.

The second electrode strip 82 is positioned on the top surface of the piezoelectric material 2 such that it is parallel to, and connected to, the second edge 22 of the top surface of the piezoelectric material 2. The second electrode strip 82 is separated from the third edge 23 by a gap. The second electrode strip 82 is separated from the fourth edge 24 by a gap.

The second electrode strip 82 is patterned such that the edge of the second electrode strip 82 that is connected to the second edge 22 has a series of notches, referred to hereinafter as "the second set of notches", each of which is indicated in Figure 7 by the reference numeral 200. In this embodiment, the second set of notches 200 comprises five notches. The notches of the second set of notches 200 are substantially rectangular. The notches of the second set of notches 200 are of substantially equal size. The notches of the second set of notches 200 are equally spaced along the edge of the second electrode strip 82 that is connected to the second edge 22 of the piezoelectric material 2.

In this embodiment, the notches in the first and second electrode strips 81, 82 are positioned such that a single notch in the first set of notches 100 is opposite a single notch in the second set of notches 200.

At step s14, a portion of the piezoelectric material 2 is removed. In this embodiment, piezoelectric material 2 adjacent to the third edge is removed such that a portion of the lower electrode 4 is exposed, and such that piezoelectric material 2 remains under the first and second electrode strips 81, 82 of the upper electrode 8.

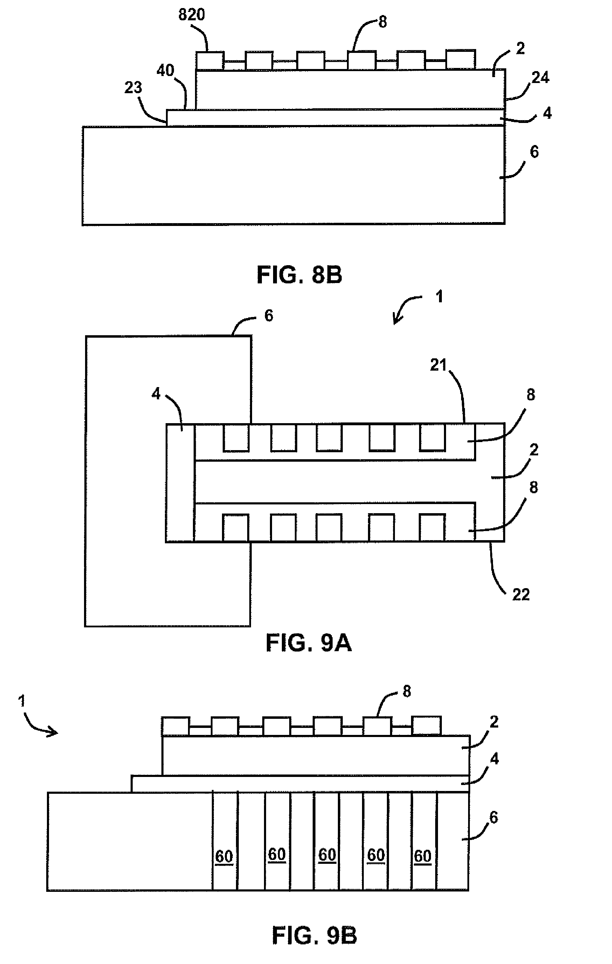

Figure 8A and Figure 8B are schematic illustrations (not to scale) of a top-down view and a side view, respectively, of a device formed by performing steps s2 to s14, as described above. The exposed portion of the lower electrode 4 forms a contact pad that is connected to a wire (not shown). The exposed portion of the lower electrode 4, hereinafter referred to as the "lower contact", is indicated in Figures 8A and 8B by the reference numeral 40. In this embodiment, a portion of the first electrode strip 81 forms a contact pad, hereinafter referred to as the "first upper contact 810", to which a wire is connected (not shown). The first upper contact 810 is the portion of the first electrode strip bounded by an edge of the first electrode strip closest to the lower contact 40 (and parallel to the third edge 23), and a notch in the first set of notches 100 that is closest to the edge of the first electrode strip closest to the lower contact 40. Similarly, a portion of the second electrode strip 82 forms a contact pad, hereinafter referred to as the "second upper contact 820", to which a wire is connected (not shown). The second upper contact 820 is the portion of the second electrode strip bounded by an edge of the second electrode strip closest to the lower contact 40 (and parallel to the third edge 23), and a notch in the second set of notches 200 that is closest to the edge of the second electrode strip closest to the lower contact 40.

At step s16, a portion of the substrate 6 is removed using a Deep Reactive-ion Etching (DRIE) process. In this embodiment, substrate material is removed such that, when viewing the device from above, i.e. from the top down, substrate material extends beyond the edges of the lower electrode 4 in a certain specific region along the boundary of the lower electrode 4. In this embodiment, this region along the boundary of the lower electrode 4 covers: the portion first edge 21 below the first upper contact 810; the third edge 23; and the portion second edge 22 below the second upper contact 820. Also, notches, hereinafter referred to as "substrate notches" are formed in the portion of the substrate 6 that is below the lower electrode 4 and does not extend beyond the boundary of the lower electrode 4 when viewed from above. The substrate notches are positioned below regions where the first electrode strip 81 and the second electrode strip 82 extend to the first edge 21 and the second edge 22 respectively, i.e. substrate material extends to the first edge 21 or the second edge 22 only where the upper electrode 8 does not extend to the first edge or the second edge 22. The substrate notches are substantially rectangular. Thus, the MEMS device is formed according to the first embodiment.

Figure 9A and Figure 9B are schematic illustrations (not to scale) of a top-down view and a side view, respectively, of the MEMS device, i.e. a device formed by performing steps s2 to s16, as described above. The MEMS device is indicated in Figure 9A and Figure 9B by the reference numeral 1. In Figure 9B, the substrate notches are indicated by the reference numeral 60.

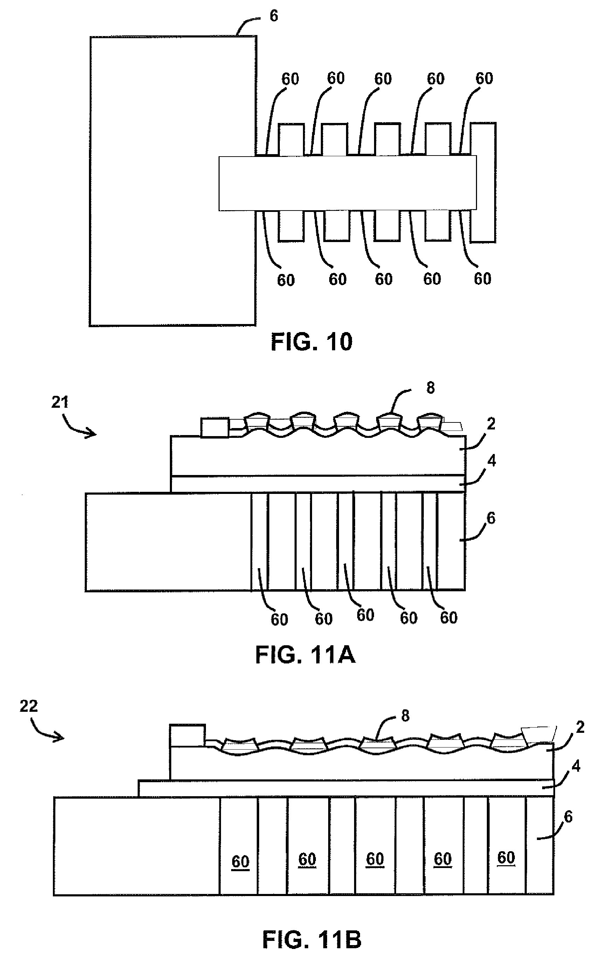

Figure 10 is a schematic illustration (not to scale) of a top down view of the substrate 6 of the MEMS device 1. For issues of clarity, i.e. so that the reader can appreciate the shape of the substrate 6 produced by performing this embodiment, the remaining elements that make up the device have been omitted. The substrate notches are indicated in Figure 10 by the reference numeral 60.

Thus, a process of fabrication of the MEMS device 1 is provided. The process of fabrication is planar, i.e. the MEMS device 1 is built in layers.

A description of the MEMS device 1 during operation will now be provided.

Figure 11A and Figure 11B are schematic illustrations (not to scale) of side views, corresponding to the first edge 21 and the second edge 22 respectively, of the MEMS device 1 during an example of operation.

In this example, a voltage is applied through the piezoelectric material 2 between the first electrode strip 81 and the lower electrode 4, and between the second electrode strip 82 and the lower electrode.

Figure 11A shows the first edge 21 of the MEMS device 1 during the operation of applying a voltage through the piezoelectric material 2 between the first electrode strip 81 and the lower electrode 4. In this example, the voltage between the first electrode strip 81 and the lower electrode 4 is applied such that the portions of the piezoelectric material 2 below the first electrode strip 81 contract in the direction parallel to the first edge 21. In other words, the voltage between the first electrode strip 81 and the lower electrode 4 is applied such that the portions of the piezoelectric material 2 below the first electrode strip 81 expand in the direction perpendicular to the plane of the piezoelectric material 2. Thus, during this example of operation, the length of the piezoelectric material 2 forming the first edge 21 gets shorter. This contraction parallel to the first edge 21 of the piezoelectric material 2 beneath the first electrode strip 81 provides that the substrate 6 along the first edge is contracted, i.e. during this example of operation, the substrate notches 60 along the first edge 21 get narrower. Thus, the MEMS device 1 is shortened along the side corresponding the first edge 21.

Figure 11B shows the second edge 22 of the MEMS device 1 during the operation of applying a voltage through the piezoelectric material 2 between the second electrode strip 82 and the lower electrode 4. In this example, the voltage between the second electrode strip 82 and the lower electrode 4 is applied such that the portions of the piezoelectric material 2 below the first electrode strip 81 expand in the direction parallel to the second edge 22. In other words, the voltage between the second electrode strip 82 and the lower electrode 4 is applied such that the portions of the piezoelectric material 2 below the second electrode strip 82 contract in the direction perpendicular to the plane of the piezoelectric material 2. Thus, during this example of operation, the length of the piezoelectric material 2 forming the second edge 22 gets longer. This expansion parallel to the second edge 22 of the piezoelectric material 2 beneath the second electrode strip 82 provides that the substrate 6 along the second edge 22 is stretched, i.e. during this example of operation, the substrate notches 60 along the second edge 22 get wider. Thus, the MEMS device 1 is lengthened along the side corresponding to the second edge 22.

The shortening of the MEMS device 1 along the first edge 21, and the lengthening of the MEMS device 1 along the second edge 22 provides that, during this example of operation, the MEMS device 1 is bent towards the first edge 21.

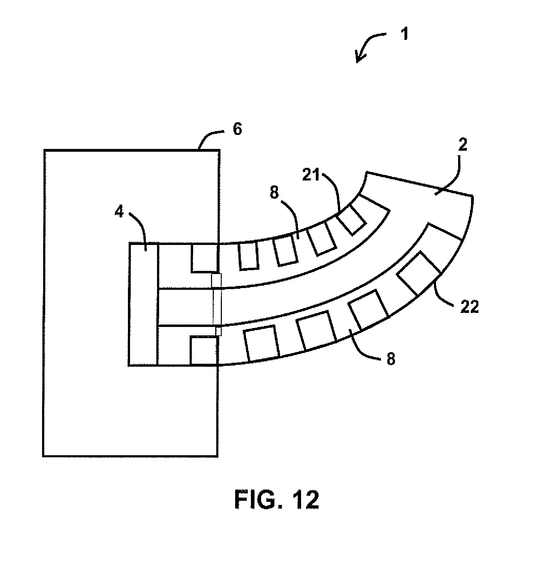

Figure 12 is a schematic illustration (not to scale) of a top down view of the MEMS device 1 during this example of operation. The MEMS device 1 is bent towards the first edge 21. This bending of the MEMS device 1 occurs in the plane in which the MEMS device 1 is fabricated. In other words, the bending of the MEMS device 1 occurs in the plane of each of the layers from which the MEMS device is fabricated (i.e. the piezoelectric material 2, the lower electrode 4, the substrate 6, and the upper electrode 8). This plane is hereinafter referred to as the "plane of fabrication".

An advantage provided by the MEMS device 1, i.e. a MEMS device capable of moving within the plane in which it is fabricated, is that systems comprising different components, for example MEMS devices that implement movement both in the plane of fabrication and out of the plane of fabrication, tend to be able to be produced on, or from, a single substrate wafer. This advantageously provides that the requirements to individually connect separate components tend to be reduced. Thus, cost and time savings tend to result.

The provided MEMS device 1 has a high level of flexibility (or compliance) in the plane of fabrication relative to level of flexibility in the through plane direction (e.g. the plane perpendicular to the plane of fabrication). This flexibility is provided for by the substrate notches 60, i.e. by removing portions of the substrate material along the first and second edges 21, 22, the rigidity of the substrate in the plane passing through these edges is reduced. Advantageously, the level or degree of flexibility of the device in the plane of fabrication can be tailored to suit the application for which the device is intended by changing the size, shape, number, and/or distribution of notches in one or both edges 21, 22 of the substrate. Thus, the displacement of the device for a given voltage applied to the piezoelectric material 2 can be tailored to suit the application for which the device is intended. For example, MEMs devices of the form described above that have different maximum displacement distances for a given voltage applied between the upper and lower electrodes can be fabricated, e.g. a MEMs device having a relatively large maximum displacement may have larger and/or more notches along the first and second edges 21, 22 of the substrate 2 compared to a MEMs device having a smaller maximum displacement.

The provided MEMS device 1 has a high level of rigidity in the plane perpendicular to the plane of fabrication, i.e. in the through-plane direction. In the above embodiment, this rigidity is provided for by the thickness of the substrate 6 in the through-plane direction. However, in other embodiments, rigidity in the through-plane direction can be provided by different means. For example, in other embodiments two similar devices may be joined together such that the bottoms of the substrate layers, i.e. the sides of the substrate that are opposite the layer of piezoelectric material, are joined together. Thus, a device having a substrate layer of double the thickness and a piezoelectric layer on opposite sides is formed. The relatively thicker substrate tends to provide increased through-plane rigidity and the two piezoelectric layers enable the thicker substrate to be bent._By virtue of the layer(s) of the piezoelectric material being thin, operating voltage levels can be made much lower than for conventional devices. For example, a voltage of 30V may be used as opposed to a conventional voltage 300V which may be used for conventional bulk devices.

In the above embodiment, the piezoelectric material is lead zirconate titanate (PZT). However, in other embodiments the layer of piezoelectric material is a different appropriate material.

In the above embodiments, the piezoelectric material has substantially uniform thickness. However, in other embodiments the layer of piezoelectric material has non uniform thickness and/or is a different appropriate shape.

In the above embodiments, the electrodes comprise a layer of chrome, and a layer of gold. However, in other embodiments the electrodes comprise one or more layers of material that may be different or the same as either gold or chrome.

In the above embodiments, the layer of chrome of the lower electrode is 50x10⁻⁹m (50nm) thick. However, in other embodiments the layer of chrome of the lower electrode is a different appropriate thickness.

In the above embodiments, the layer of gold of the lower electrode is 0.5x10⁻⁶m (0.5µm) thick. However, in other embodiments the layer of gold of the lower electrode is a different appropriate thickness.

In the above embodiments, the substrate is silicon. However, in other embodiments the substrate is a different appropriate material.

In the above embodiments, the substrate is 500x10⁻⁶m (500µm) thick. However, in other embodiments the substrate is a different appropriate thickness.

In the above embodiments, at step s8 of the above described process the piezoelectric material is thinned by grinding down the piezoelectric material until it is 20x10⁻⁶m (20µm) thick. However, in other embodiments the piezoelectric material is thinned by a different appropriate process. Also, in other embodiments the piezoelectric material is thinned to a different appropriate thickness.

In the above embodiments, the upper electrode comprises a layer of chrome, and a layer of gold. However, in other embodiments the upper electrode comprises one or more layers of material that may be different or the same as either gold or chrome.

In the above embodiments, the layer of chrome of the upper electrode is 50x10⁻⁹m (50nm) thick. However, in other embodiments the layer of chrome of the upper electrode is a different appropriate thickness.

In the above embodiments, the layer of gold of the upper electrode is 0.5x10-⁶m (0.5µm) thick. However, in other embodiments the layer of chrome of the upper electrode is a different appropriate thickness.

In the above embodiments, at step s12 the upper electrode is patterned such that it forms first and second electrode strips. However, in other embodiments the upper electrode is patterned in a different manner so as to provide the same functionality of the MEMS device. For example, in other embodiments the upper electrode is patterned so that a single electrode strip is positioned along the first or second edge of the top surface of the piezoelectric material. In other embodiments, the upper electrode is patterned such that two or more electrode strips are positioned down the first and/or second edge of the piezoelectric material.

In the above embodiments, at step s12 the first and second electrode strips are patterned such that a respective first and second set of notches are formed in the respective first and second strip. There are five notches in each strip. The notches are substantially the same size. The notches are substantially rectangular. However, in other embodiments there is a different number of notches in one or both electrode strips. Moreover, in other embodiments, some or all of the notches in either the first or second strip are of different size and/or shape.

In the above embodiments, the notches in the first and second electrode strip are formed such that they are positioned opposite each other. However, in other embodiments, some or all of the notches of one electrode strip are positioned such that they are not opposite the notches of the other. For example, in other embodiments the notches of one electrode are offset with respect to those of the other.

In the above embodiments, upper and lower contacts are formed as described in greater detail with reference to step s14 and Figure 8A and 8B. However, in other embodiments, upper and lower contacts are formed from different portions of the upper and lower electrodes respectively.

In the above embodiments, at step s16 a portion of the substrate is removed using a Deep Reactive-ion Etching (DRIE) process. However, in other embodiments, a different process is used.

In the above embodiment, at step s16 substrate material is removed such that, when viewing the device from above, substrate material extends beyond the edges of the lower electrode in a certain specific region along the boundary of the lower electrode. However, in other embodiments different portions of the substrate are removed that provide the same overall functionality of the MEMS device.

In the above embodiments, substrate notches are formed in the portion of the substrate below the lower electrode. Also in the above embodiments, the substrate notches are positioned below regions where the first electrode strip and the second electrode strip extend to the first edge and the second edge respectively. The substrate notches are substantially rectangular. However, in other embodiments the substrate notches are positioned differently so as to provide the same functionality for the MEMS device. In other embodiments, some or all of the substrate notches are different sizes and/or shapes.

The possibility of differently sized and/or shaped substrate notches, and/or the differently sized and/or shaped notches in the upper electrode, tends to provide that the ease with which the MEMS device bends, and/or the extent to which the MEMS device bends, can be controlled. This advantageously tends to allow differently geared MEMS devices that bend within the plane of fabrication to be fabricated.

In the above embodiments, the MEMS device is produced by sequentially performing steps s2 to s16 of the fabrication process described above with reference to Figure 1. However, in other embodiments the same or different method steps are performed in the same or a different order so as to provide a MEMS device having the same functionality as that described above.

In the above embodiments, an operation of the MEMS device is described. The operation of the MEMS device causes the MEMS device to bend in the plane of its fabrication towards the first edge. However, in other embodiments different operations are performed on the MEMS device. For example, in embodiments in which the upper electrode is patterned such that that two or more electrode strips are positioned along an edge of the piezoelectric material, e.g. the first edge, an operation that expands a portion of this edge and contracts a different portion of this edge, thereby producing an 'S-shaped' bend in the MEMS device, is performed.

In the above embodiments, the lower electrode, piezoelectric material, and upper electrode are layered upon a single side of the substrate, i.e. the top side of the substrate. However, in other embodiments, these layers are deposited on more than one side of the substrate. For example, in other embodiments lower electrodes, piezoelectric material layers and upper electrodes are deposited on opposite sides the substrate, for example the side and a bottom side of the substrate, so as to provide the same functionality. This configuration advantageously provides that a lower voltage tends to be required to produce a certain amount of movement in the MEMS device. A further advantage of this configuration is that bending of the device out of the plane of fabrication tends to be minimised.

## Claims

1. A MEMS device having a moveable portion, the moveable portion comprising a layer of material (6) having relatively low rigidity in a direction in the plane of a surface of the layer of material (6), and relatively high rigidity in a direction through the plane of the surface; wherein
the relatively low rigidity is provided by a plurality of alternating ridges and grooves (60) in a further surface of the layer of material (6), the further surface of the material (6) being substantially perpendicular to the direction in the plane of a surface of the layer of material (6).

2. A MEMS device according to claim 1, wherein the layer of material (6) is a substrate layer formed from a substrate wafer.

3. A MEMS device according to claim 2, wherein the plane of the surface of the layer of material (6) is the plane of the substrate wafer onto which the MEMS device is formed.

4. A MEMS device according to any of claims 1 to 3, wherein the MEMS device is a piezoelectric actuator.

5. A MEMS device according to claim 4, further comprising a layer of piezoelectric material (2) bonded to the surface of the layer of material (6), wherein actuation of the MEMS device is performed by applying an electrical field across the layer of piezoelectric material.

6. A MEMS device according to any of claims 1 to 5, wherein actuation of the MEMS device is in the plane of the surface of the layer of material (6).

7. A MEMS device according to claim 6, wherein actuation of the MEMS device is bidirectional within the plane of the surface of the layer of material (6).

8. A MEMS device according to any of claims 1 to 7, wherein the MEMS device is adapted to provide a pre-determined actuation force and/or actuation displacement by varying, during fabrication of the MEMS device, one or more of the following:
the number of alternating ridges and grooves (60);
the distribution of the ridges and grooves (60) in the further surface;
the depth of one or more of the plurality of grooves (60) relative to the ridges;
the width of one or more of the plurality of ridges; and
the width of one or more of the plurality of grooves (60).

9. A method of fabricating a MEMS device, the method comprising the steps of:
providing a layer of material (6) having relatively high rigidity in a direction through the plane of a surface of the layer of material (6); and
forming a plurality of alternating ridges and grooves (60) in a further surface of the layer of material (6), the further surface of the material (6) being substantially perpendicular to a direction in the plane of a surface of the layer of material (6), such that the layer of material (6) has relatively low rigidity in the direction in the plane of a surface of the layer of material (6).

10. A method according to claim 9, wherein the layer of material (6) is a substrate layer formed from a substrate wafer, and the plane of the surface of the layer of material (6) is the plane of the substrate wafer onto which the MEMS device is formed.

11. A method according to claims 9 or 10, the method further comprising adapting the MEMS device to provide a pre-determined actuation force and/or actuation displacement by performing one or more of the following steps:
determining the number of alternating ridges and grooves (60);
determining the distribution of the ridges and grooves (60) in the further surface;
determining the depth of one or more of the plurality of grooves (60) relative to the ridges;
determining the width of one or more of the plurality of ridges; and
determining the width of one or more of the plurality of grooves (60).

12. A method according to any of claims 9 to 11, the method further comprising the step of bonding a layer of piezoelectric material (2) to the surface of the layer of material (6).

13. A method of actuating a MEMS device, wherein the MEMS device is fabricated according to the method of claim 12, and the method of actuation comprises the step of applying an electrical field across the layer of piezoelectric material (2).

14. A method according to claim 13, wherein the actuation of the MEMS device is bidirectional within the plane of the surface of the layer of material (6).
